(19) Europäisches Patentamt
European Patent Office
Office européen des brevets

(11) **EP 1 783 917 A1**

(12) **EUROPEAN PATENT APPLICATION**

(43) Date of publication:
**09.05.2007 Bulletin 2007/19**

(51) Int Cl.:
***H03M 13/29*** *(2006.01)*

(21) Application number: **05447247.7**

(22) Date of filing: **07.11.2005**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU**<br><br>(71) Applicant: **UNIVERSITE CATHOLIQUE DE LOUVAIN**<br>**1348 Louvain-la-Neuve (BE)** | (72) Inventors:<br> • **VandenDorpe, Luc**<br>  **1348 Louvain-la-Neuve (BE)**<br> • **Sneessens, Harold**<br>  **5081 Bovesse (BE)**<br><br>(74) Representative: **Van Malderen, Joëlle et al**<br>  **pronovem - Office Van Malderen**<br>  **Avenue Josse Goffin 158**<br>  **1082 Bruxelles (BE)** |

(54) **Method for coded modulation and device therefor**

(57)     The present invention relates to a method for the coded modulation of a sequence of bits ($u$), comprising the steps of :
- determining for a coded version ($x$) of said sequence of bits ($u$) soft values related to the probability of individual bits of said coded version ($x$),
- calculating the probabilities of symbols to which bits of said coded version ($x$) of said sequence of bits ($u$) can be mapped, whereby said symbols belong to a given set of symbols,
- deriving a modulated signal comprising information on said calculated symbol probabilities.

$$n_{eq} \quad (\sigma^2)$$

**Fig.2**

EP 1 783 917 A1

Printed by Jouve, 75001 PARIS (FR)

**Description**

**Field of the invention**

The present invention relates to the field of error-correcting codes and modulation. More particularly, it addresses the problem of coded modulation under the assumption that some a priori information is available on the data to encode.

**State of the art**

Encoders for error-correcting codes and digital modulators take as input sequences of bits. For example, a convolutional encoder of rate 1/n produces a coded sequence $\mathbf{x} = [x_1(1), ..., x_n(1), ..., x_1(K), ..., x_n(K)]^T$ from a given sequence of information bits $\mathbf{u} = [u(1), ..., u(K)]^T$. Such encoders are commonly used in numerous types of communication systems to protect information bits to be transmitted against errors introduced due to channel degradation.

In a particular application such an encoder is used in cooperation schemes used to improve communication between mobile receivers. Cooperation between mobiles provides spatial diversity and thus improves communications on fading wireless channels. This cooperative diversity is particularly suited to cases where the mobiles cannot support multiple antennas.

Relaying techniques commonly used for user cooperation are Amplify-Forward (AF) and Decode-Forward (DF). In the AF technique the relay simply amplifies its partner's signal and forwards it to the destination. The DF technique consists in decoding, re-encoding and forwarding the partner's signal to the destination. DF lacks the main advantages of AF and vice versa : DF regenerates the signal while AF does not lose soft information.

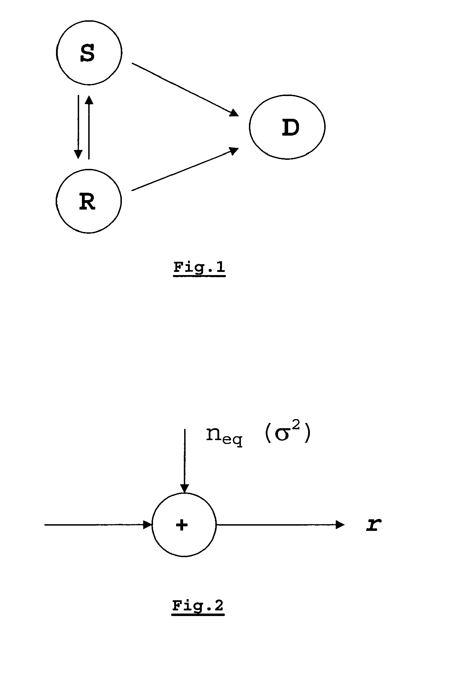

A particular case of two users transmitting to a same destination is considered now. The inter-users channels as well as the uplink channels are mutually independent Rayleigh block fading channels. They are frequency-flat and orthogonal. After the transmission by each source user in a first time slot, each partner relays the signal in a second time slot. The ratio of the second time slot duration to the total duration is defined as the cooperation ratio. The channels are assumed constant during both time slots, and are perfectly known by the corresponding receivers so that coherent detection is used. The destination uses both the direct and relayed signals to make a joint decision. Although both users cooperate in a symmetric fashion, the focus will be on one source signal in order to simplify notations. One user is considered as the source S and the other as its relay R, transmitting to a destination D (see Fig.1).

For BPSK modulation, the baseband equivalent discrete time signal of user $i \in \{S,R\}$ received by user $j \in \{R, D\}$ $(i \neq j)$ at time n is

$$r_{ij}(n) = h_{ij}\sqrt{E_{s,i}} \cdot b_i(n) + n_j(n) \qquad (\text{eq.1})$$

which describes the transmission of BPSK symbols $b_i(n)$ with an energy per symbol $E_{s,i}$, experiencing fading of magnitude $h_{ij}$ and additive noise at the reception $n_j(n)$. The model assumes that the fading magnitudes $h_{ij}$ are independent Rayleigh-distributed samples and that the noise terms $n_j(n)$ are samples of a zero-mean white Gaussian noise process with two-sided power spectral density $N_j/2$.

Relays using the AF technique simply amplify and re-transmit their partner coded data. The relay chooses a constant amplification factor such that the average energy per symbol over the consecutive frames equals its average symbol energy $E_{s,R}$. During the first time slot, the signal from the source user S is received at the relay R and at the destination D respectively as

$$r_{SR}(n) = h_{SR}\sqrt{E_{s,S}} \cdot b_S(n) + n_R(n) \qquad (\text{eq.2})$$

$$r_{SD}(n) = h_{SD}\sqrt{E_{s,S}} \cdot b_S(n) + n_D(n) \qquad (\text{eq.3})$$

The relay amplifies the signal by a normalization factor

$$\beta_R = \sqrt{\frac{E_{s,R}}{E[h_{SR}^2]E_{s,S} + N_R}} \qquad (\text{eq.4})$$

where $E[.]$ denotes the expectation operator, and transmits it during the second time slot. The destination receives this relayed signal as :

$$r_{RD}(n) = h_{RD}(n)\,\beta_R\, r_{SR}(n) + n_D(n) \qquad (\text{eq.5})$$

and then combines this path optimally with the direct path and decodes the signal.

With the DF technique, the relay decodes its partner's signal, makes hard decisions (i.e. it decides whether a '1' or a '-1' was transmitted) and checks if errors occurred thanks to a parity check code. Erroneous frames are not relayed since it would break down the performance at destination, but successfully decoded frames are re-encoded, possibly with another code, and forwarded to the destination. In this case, the destination receives during the second time slot the following signal :

$$r_{RD}(n) = h_{RD}(n)\sqrt{E_{s,R}}\,\bar{b}_R(n) + n_D(n) \quad (\text{eq.6})$$

An adequate choice of the codes makes possible to construct a cooperative turbo coded scheme, for which an appropriate iterative decoding algorithm is used at the destination. This happens if both the source user and the relay use convolutional codes, provided that the relay interleaves the data before re-encoding. This leads to the interpretation of DF as the partition of a user's codeword, the first part of which is transmitted by the source user and the second by the relay. The main advantage of AF over DF is that no hard decisions are made, but on the contrary AF does not regenerate the signal.

US patent application 2004/0177308 to an apparatus and method for encoding and decoding comprising at the transmitter side a cascade of two soft encoders (e.g. an Low Density Parity Check (LDPC) encoder and a turbo encoder) and at the receiver side a cascade of two soft decoders. Optionally an interleaver and deinterleaver are provided between the encoders and decoders, respectively.

In the paper 'An iterative decoding method of updating redundant likelihood information', Ariyoshi et al., IEICE Trans.Comm., vol. E88-B, no.3, March 2005, pp.1045-1053, a decoding algorithm for turbo codes in presented wherein a soft-input soft-output recursive systematic convolutional encoder is used in order to make the decoding process more reliable.

The paper 'Decode-Amplify-Forward (DAF) : a new class of Forwarding Strategy for Wireless Relay Channels', Xingkai Bao et al., IEEE Workshop on Signal Processing Advances in Wireless Communications, June 6, 2005, presents a technique that combines the merits of both decode-forward and amplify-forward. It tackles thus the same problem as previously explained. In the proposed solution the relay first soft decodes the error correcting code and then amplifies the log-likelihood ratio values for each bit at the output of the decoder. Next the outputs are forwarded to the destination.

## Aims of the invention

The present invention aims to provide a method and device for the coded modulation of a sequence of bits that overcome the drawbacks of the prior art solutions. The method can be applied for improving the communication over relay channels.

## Summary of the invention

The present invention relates to a method for the coded modulation of a sequence of bits (u), comprising the steps of :

- determining for a coded version (x) of the sequence of bits (u) soft values related to the probability of individual bits of the coded sequence (x),
- calculating the probabilities of symbols to which bits of said coded version (x) of said sequence of bits (u) can be mapped, whereby said symbols belong to a given set of symbols,

- deriving a modulated signal comprising information on said calculated symbol probabilities.

In a preferred embodiment the soft values are derived using a priori information P(u) on the probabilities of bits of the bit sequence. Advantageously the soft values are derived by means of a maximum a posteriori (MAP) algorithm.

Preferably the step of deriving a modulated signal comprises a computation of the projection of the modulated signal on two non-parallel axes, each determined by two symbols of said set of symbols.

In another embodiment the method further comprises the step of multiplying the modulated signal with a constant factor to normalise the transmitted energy.

The invention also relates to a method for relaying coded data transmitted by a source to a destination via a relay, comprising the steps of

- decoding the transmitted coded data in the relay, yielding a decoded bit sequence, and
- performing in the relay the method for coded modulation as previously described on said decoded bit sequence.

In a preferred embodiment the method for relaying coded data further comprises the step of forwarding the modulated signal to the destination.

Preferably the coded data transmitted by the source are convolutionally encoded and modulated.

After the step of decoding an interleaving operation is optionally performed on the decoded bit sequence.

In another aspect the invention relates to a device for performing the method for coded modulation as above described.

### Short description of the drawings

Fig. 1 represents a cooperative system.

Fig. 2 represents the equivalent channel.

### Detailed description of the invention

The present invention extends the field of error-correcting codes and modulation by using 'soft inputs and soft outputs' that take into account the possible uncertainty of the bits. The outputs produced by these encoders and modulators comprise the uncertainty information. The output of a soft encoder for example, is not a hard value of '1' or '-1', but a soft value such as '0.85' or '-0.85', where the soft value itself is related to the probability of a bit value being '1' (logical '1') or '-1' (logical '0'). The encoding and modulation method and devices both take as input a measure of the probabilities on the bits. Since soft values are taken as input and soft output values are produced, these techniques are referred to as soft input - soft output (SISO) encoding and modulation techniques.

Transmission of data known with uncertainty occurs for example in relays as previously discussed. Obviously, the SISO encoding and modulation methods according to the invention can advantageously be applied in a relay scheme, as it allows regenerating the signal, while keeping the soft information. A relay using this technique first decodes its partner's signal, keeping soft information, interleaves and re-encodes it with a soft-input soft-output (SISO) encoder and finally deducts the signal to transmit thanks to an equivalent channel assumption on the outputs of the modulator (cfr. infra).

The SISO coding technique presented here applies to non-recursive convolutional codes. The objective of the SISO encoder is to compute the probabilities of the coded bits given the probabilities of the information bits. As opposed to a convolutional encoder which produces nK coded bits $x_i(k)$ ($k=1,...,K$ and $i=1,...,n$ where $1/n$ is the code rate) given the information bits u, the SISO encoder computes the probabilities $P(x_i(k))$, $i=1,...,n$ on the coded bits $x_i$ (k), given the probabilities $P(u(k))$ on the information bits. These probabilities are computed with an encoding maximum a posteriori (MAP) algorithm. The state of a convolutional encoder at time k is denoted $s(k)$. The code introduces constraints between the input $u(k)$, the outputs $x_i(k)$ ($i=1,...,n$), the state $s(k-1)$ (encoder state at time $k-1$) and the state $s(k)$. For example, a combination of the state $s(k-1)$ and the input bit $u(k)$ uniquely determines the state $s(k)$ and the output bits $x_i(k)$ ($i=1,..., n$). A function $T(u(k), s(k-1), s(k), x_1(k),...,x_n(k))$ is introduced which takes the value 1 if the values of its parameters satisfy the code constraints (i.e. they represent a valid transition in the trellis associated to the convolutional code), and otherwise takes the value 0.

The encoding maximum a posteriori (MAP) algorithm first involves the computation of a forward recursion $\alpha(.)$ and a reverse recursion $\beta(.)$, and finally the computation of the desired probabilities. For an encoder of state $s(k)$ at time k, the following recursions can be written, where each term in the summation has to correspond to a combination of $(s(k-1), u(k), x_i(k), s(k))$ satisfying the following constraints:

$$\alpha(\mathbf{s}(k)) = \sum_{\square \mathbf{s}(k)} \alpha(\mathbf{s}(k-1)) \cdot P(u(k)) \cdot T(u(k), s(k-1), s(k), x_1(k), \ldots, x_n(k)) \qquad (\text{eq. } 7)$$

$$\beta(\mathbf{s}(k-1)) = \sum_{\square \mathbf{s}(k-1)} \beta(\mathbf{s}(k)) \cdot P(u(k)) \cdot T(u(k), s(k-1), s(k), x_1(k), \ldots, x_n(k)) \qquad (\text{eq. } 8)$$

wherein $\Sigma_{\square s(k)}$ denotes the summation over all possible values of each variable but **s(k)** (i.e. the marginal relative to **s(k)**). Finally $P(x_i(k))$ is computed :

$$P(x_i(k)) = \sum_{\square x_i(k)} \alpha(\mathbf{s}(k-1)) \cdot \beta(\mathbf{s}(k)) \cdot P(u(k)) \cdot T(u(k), s(k-1), s(k), x_1(k), \ldots, x_n(k)) \quad (\text{eq. } 9)$$

From the probabilities on the coded bits and for a given alphabet of symbol $S = \{s_1, \ldots, s_m\}$, the modulator computes a soft output r to transmit. Each soft output of the sequence r can be interpreted as a being a symbol of S corrupted by additive noise. This additive noise carries the uncertainty information.

The first step is to translate the probabilities on the coded bits to probabilities on the symbols of S. For each symbol $s_i$, $i=1,\ldots,$ m, the probability $P(s_i)$ a hard modulator (i.e. a non-SISO modulator) would produce $s_i$ as output, depends on the probabilities $P(x_i)$ of each bit of the input sequence $\{x_1, \ldots, x_q\}$, where q is the number of bits mapped onto one symbol. Assuming the independence of the bits, the probabilities on the symbols $s_i$ are computed as follows :

$$P(s_i) = \prod_{p=1}^{q} P(x_p), \qquad i = 1, \ldots, m \qquad (\text{eq.} 10)$$

for values of the bits $\{x_1, \ldots, x_q\}$ corresponding to the symbol $s_i$ under conventional 'hard' coding.

A Gaussian channel assumption on these probabilities $P(S_i)$, $i=1, \ldots,$ m enables finding the soft signal to transmit. More precisely, this assumption consists in regarding the uncertainty on the symbols $S_i$ as the consequence of the transmission of a symbol of S through an equivalent noisy channel, where the noise $n_{eq}$ has a variance $\sigma^2$ (see Fig.2). It is further assumed that the equivalent channel is an additive white Gaussian noise (AWGN) channel. As a consequence of these assumptions, the distribution $P(s_i)$, $i=1, \ldots,$ m is regarded as the distribution $P(s_i|r)$, $i=1, \ldots,m$ describing the output $r$ of the equivalent channel. This will enable to find the signal r, which is considered as the signal to transmit (i.e. the output of the SISO modulator). The Gaussian assumption is well suited to many practical situations.

The variance $\sigma^2$ can be computed from the statistical properties of the bits at the input of the SISO encoder-modulator in the following way. If the uncertainty on the bits results from their previous reception through a noisy channel, the relation between the noise variance on this channel and the variance $\sigma^2$ can be computed empirically. In other cases, the uncertainty on the information bits can be interpreted as a consequence of their transmission on a noisy channel with a given noise variance, and the relation between this variance and $\sigma^2$ can also be computed empirically.

The output signal r is found by the computation of its projections on two non-parallel axes of the complex plane. Each of these axes is determined by two opposite symbols of the alphabet, i.e. $s_i$ and $s_j$, $1 \leq i,j \leq n$, with $i \neq j$ and $s_j = -s_i$. These projections are computed from the distribution by computing the following log ratio (LR) :

$$LR(s_i, s_j) \square \log \frac{P(s = s_i \mid r)}{P(s = s_j \mid r)} \quad (\text{eq.} 11)$$

Under the Gaussian assumption on the distribution of symbols and using $s_j = -s_i$ one obtains :

$$LR(s_i, s_j) = \frac{2}{\sigma^2} \operatorname{Re}(r \cdot s_i^*) \qquad (\text{eq.12})$$

where $s_i^*$ denotes the complex conjugate of $s_j$. Decomposing r and $s_j$ in their real and imaginary part as $r=x+iy$ and $s_j$ =a+ib the log ratio becomes

$$LR(s_i, s_j) = \frac{2}{\sigma^2}(ax + by) \qquad (\text{eq.13})$$

Choosing another pair of opposite symbols one can compute another projection of r. From these two projections it is then easy to find x and y and thus r.

An example is given for the case of an alphabet of QPSK symbols $S = \{1, j, -1, -j\}$ (where $j^2=-1$). The projections are computed on the axes defined by the pairs of opposite symbols. The first axis is thus the line joining the symbols 1 and -1, and the second is the line joining the symbols $j$ and $-j$. For the first axis the log-ratio is

$$LR(1, -1) = \frac{2}{\sigma^2} \operatorname{Re}(r.1) \qquad (\text{eq.})$$

according to eq. (12). In this case, the first projection $LR(1,-1)$ enables to find the real part of the signal r :

$$\operatorname{Re}(r) = LR(1, -1)\frac{\sigma^2}{2} \qquad (\text{eq.})$$

For the second axis one can write :

$$LR(j, -j) = \frac{2}{\sigma^2} \operatorname{Re}(r.(-j)) \qquad (\text{eq.})$$

and thus the imaginary part of r becomes

$$\operatorname{Im}(r) = LR(j, -j)\frac{\sigma^2}{2} \qquad (\text{eq.})$$

With the two projections one has found the soft symbol r to transmit.

By choosing two symbols lying on the real axis and two on the imaginary axis, the projections provide directly and separately x and y. In the particular case of BPSK modulation, the log ratio above taken for the two BPSK symbols is the well-known log-likelihood-ratio. No second projection is needed since the BPSK symbols always lie on the real axis.

Finally the modulator constructs the signal $\beta r = \beta(x + iy)$ where the factor $\beta$ ensures the normalization of the transmitted energy. This signal can be interpreted as being a symbol of the alphabet S corrupted by an additive noise of variance $\sigma^2$. This additive noise models the uncertainty inferred from the distribution of the symbols at the modulator input.

The SISO encoders and modulators enables the design of SISO regenerating relays. A basic configuration is the following one: a source transmitter transmits information bits after convolutional encoding and modulation. A relay decodes these information bits with a SISO decoding method. The knowledge of the probabilities on the decoded bits enables a SISO encoding and a SISO modulation. Finally, the signal retransmitted by the relay is received by the destination.

Since the destination can possibly get several encoded copies of the information bits of the source user and in order to enable a joint decoding of these sequences, it can be useful that the relay uses an interleaver between the output of its SISO decoder and the input of its SISO encoder. With such a coding scheme, the reception can perform a turbo-decoding of the coded copies of the signal it gets.

**Claims**

1. Method for the coded modulation of a sequence of bits (u), comprising the steps of :

   - determining for a coded version (x) of said sequence of bits (u) soft values related to the probability of individual bits of said coded version (x),
   - calculating the probabilities of symbols to which bits of said coded version (x) of said sequence of bits (u) can be mapped, said symbols belonging to a given set of symbols,
   - deriving a modulated signal comprising information on said calculated symbol probabilities.

2. Method for modulating a sequence of bits as in claim 1, wherein said soft values are derived using a priori information P(u) on the probabilities of bits of said sequence of bits.

3. Method for modulating a sequence of bits as in claim 2, wherein said soft values are derived by means of a maximum a posteriori (MAP) algorithm.

4. Method for modulating a sequence of bits as in claim 1, 2 or 3, wherein said step of deriving a modulated signal comprises computing the projection of said modulated signal on two non-parallel axes, each determined by two symbols of said set of symbols.

5. Method for modulating a sequence of bits as in any of claims 1 to 4, further comprising the step of multiplying said modulated signal with a constant factor to normalise the transmitted energy.

6. Method for relaying coded data transmitted by a source to a destination via a relay, comprising the steps of

   - decoding said transmitted coded data in said relay, yielding a decoded bit sequence, and
   - performing in said relay the method for coded modulation as in any of the previous claims on said decoded bit sequence.

7. Method for relaying coded data as in claim 6, further comprising the step of forwarding said modulated signal to said destination.

8. Method for relaying coded data as in claim 6 or 7, wherein said coded data transmitted by said source are convolutionally encoded and modulated.

9. Method for relaying coded data as in any of claims 6 to 8, wherein after said step of decoding an interleaving operation is performed on said decoded bit sequence.

10. Device for performing the method for coded modulation as in any of claims 1 to 5.

Fig.1

$$n_{eq} \ (\sigma^2)$$

$r$

Fig.2

# EP 1 783 917 A1

## EUROPEAN SEARCH REPORT

**European Patent Office**

**Application Number**

EP 05 44 7247

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAROLD H. SNEESSENS, LUC VANDENDORPE: "SOFT DECODE AND FORWARD IMPROVES COOPERATIVE COMMUNICATIONS" INTERNET ARTICLE, [Online] 11 October 2005 (2005-10-11), XP002371812 Retrieved from the Internet: URL:http://www.tele.ucl.ac.be/digicom/snee ssens/papers/CAMSAP_2005.pdf> [retrieved on 2006-03-10] * the whole document * | 1-10 | H03M13/29 |
| A,D | XINGKAI BAO, JING LI (TIFFANY): "Decode-Amplify-Forward (DAF): A New Class of Forwarding Strategy for Wireless Relay Channels" IEEE WORKSHOP ON SIGNAL PROCESSING ADVANCES IN WIRELESS COMMUNICATIONS, [Online] 6 June 2005 (2005-06-06), XP002371813 Retrieved from the Internet: URL:http://www.eecs.lehigh.edu/~jingli/pub /paper/SPAWC2005_DAF.pdf> [retrieved on 2006-03-13] * the whole document * | 1-10 | |
| D,A | ARIYOSHI M ET AL: "AN ITERATIVE DECODING METHOD OF UPDATING REDUNDANT LIKELIHOOD INFORMATION" IEICE TRANSACTIONS ON COMMUNICATIONS, COMMUNICATIONS SOCIETY, TOKYO, JP, vol. E88-B, no. 3, March 2005 (2005-03), pages 1045-1053, XP001225582 ISSN: 0916-8516 * the whole document * * page 1048, column 2 - page 1049, column 1 * | 1-10 | |

**TECHNICAL FIELDS SEARCHED (IPC)**

H03M

-/--

The present search report has been drawn up for all claims

| Place of search | Date of completion of the search | Examiner |
|---|---|---|
| The Hague | 14 March 2006 | Rydyger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

9

EP 1 783 917 A1

| European Patent Office | EUROPEAN SEARCH REPORT | Application Number |
|---|---|---|
| | | EP 05 44 7247 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2005/166129 A1 (YANO TETSUYA ET AL) 28 July 2005 (2005-07-28) * figure 10 * | 1-10 | |
| A | US 2004/177308 A1 (KIM KI-HYUN ET AL) 9 September 2004 (2004-09-09) * figure 1 * * figure 2 * * the whole document * | 1-10 | |
| A | ZHAO FANG ET AL: "Joint turbo channel detection and rll decoding for (1, 7) coded partial response recording channels" ICC 2003. 2003 IEEE INTERNATIONAL CONFERENCE ON COMMUNICATIONS. ANCHORAGE, AK, MAY 11 - 15, 2003, IEEE INTERNATIONAL CONFERENCE ON COMMUNICATIONS, NEW YORK, NY : IEEE, US, vol. VOL. 1 OF 5, 11 May 2003 (2003-05-11), pages 2919-2923, XP010642979 ISBN: 0-7803-7802-4 * the whole document * * figure 1 * | 1-10 | TECHNICAL FIELDS SEARCHED (IPC) |

The present search report has been drawn up for all claims

| Place of search | Date of completion of the search | Examiner |
|---|---|---|
| The Hague | 14 March 2006 | Rydyger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

10

## ANNEX TO THE EUROPEAN SEARCH REPORT
## ON EUROPEAN PATENT APPLICATION NO.

EP 05 44 7247

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2006

| Patent document cited in search report | | Publication date | Patent family member(s) | | Publication date |
|---|---|---|---|---|---|
| US 2005166129 | A1 | 28-07-2005 | NONE | | |
| US 2004177308 | A1 | 09-09-2004 | JP | 2004312687 A | 04-11-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040177308 A

### Non-patent literature cited in the description

- **ARIYOSHI et al.** An iterative decoding method of updating redundant likelihood information. *IEICE Trans.Comm.,* March 2005, vol. E88-B (3), 1045-1053

- **XINGKAI BAO et al.** Decode-Amplify-Forward (DAF) : a new class of Forwarding Strategy for Wireless Relay Channels. *IEEE Workshop on Signal Processing Advances in Wireless Communications,* 06 June 2005